## Europäisches Patentamt
## European Patent Office
## Office européen des brevets

(11) Veröffentlichungsnummer : **0 181 355**
**B1**

(12) **EUROPÄISCHE PATENTSCHRIFT**

(45) Veröffentlichungstag der Patentschrift :
**19.10.88**

(21) Anmeldenummer : **85901969.7**

(22) Anmeldetag : **16.04.85**

(86) Internationale Anmeldenummer :
**PCT/DE 85/00118**

(87) Internationale Veröffentlichungsnummer :
**WO/8505497 (05.12.85 Gazette 85/26)**

(51) Int. Cl.⁴ : **H 01 L 27/08**, H 01 L 29/06, H 01 L 29/08

(54) MONOLITHISCH INTEGRIERTE PLANARE HALBLEITERANORDNUNG. .

(30) Priorität : **11.05.84 DE 3417474**

(43) Veröffentlichungstag der Anmeldung :
**21.05.86 Patentblatt 86/21**

(45) Bekanntmachung des Hinweises auf die Patenterteilung : **19.10.88 Patentblatt 88/42**

(84) Benannte Vertragsstaaten :
**AT DE FR GB IT NL SE**

(56) Entgegenhaltungen :
**WO-A-83 /025 28**
**DE-A- 3 227 536**
**E.D.N. Electrical Design News, Band 28, Nr. 3, Februar 1980, Boston (US) Travis: "Bipolar power semis improbe performance as FET's exhibit innovative enhancements", Seiten 41-56**

(73) Patentinhaber : **ROBERT BOSCH GMBH**
**Postfach 50**
**D-7000 Stuttgart 1 (DE)**

(72) Erfinder : **FLOHRS, Peter**
**Wallensteinstrasse 38**
**D-7410 Reutlingen 11 (DE)**
Erfinder : **MICHEL, Hartmut**
**Herderstrasse 74**
**D-7410 Reutlingen (DE)**

Jouve, 18, rue St-Denis, 75001 Paris, France

**Beschreibung**

Stand der Technik

Die Erfindung geht aus von einer Halbleiteranordnung nach der Gattung des Hauptanspruchs. Aus der DE-OS 3 227 536 ist eine als Darlington-Transistorschaltung ausgebildete Halbleiteranordnung bekannt, bei der die beiden Transistoren in einem gemeinsamen Substrat in Planartechnik monolithisch integriert sind. Das Substrat bildet dabei die Kollektorzonen der beiden Transistoren. Auf der Hauptoberfläche des Substrats befindet sich eine aus Siliziumdioxid bestehende Passivierungsschicht, die diese Hauptoberfläche mit Ausnahme von Kontaktfenstern überdeckt. Dis Basis-Kollektor-Übergänge der beiden Transistoren sind durch eine Metallelektrode geschützt, die sich über der Passivierungsschicht befindet und als Deckelektrode bezeichnet werden kann. Diese Halbleiterschaltung besitzt außerdem einen integrierten Spannungsteiler, dessen Abgriff mit der Deckelektrode verbunden ist. Das von der Deckelektrode ausgehende elektrostatische Feld beeinflußt die Durchbruchsspannung an den darunter befindlichen Basis-Kollektor-Übergängen, die hier als pn-Übergänge ausgebildet sind. Durch geeignete Wahl des Spannungsteilers kann eine Einstellung der Durchbruchsspannung vorgenommen werden, die jedoch bei der bekannten Halbleiteranordnung durch den Sperrstrom in unerwünschter Weise beeinflußt werden kann. Fließt der Sperrstrom nicht nur in die Basis, sondern auch in den Widerstandsstreifen, so kann dies zu einer Verstimmung des Spannungsteilers und damit zu einer starken Abhängigkeit der Durchbruchsspannung vom Sperrstrom führen. Dient die Anordnung zur Klammerung der Emitter-Kollektor-Sperrspannung, indem der Sperrstrom in die Basis den Transistor aufsteuert, so führt die Verstimmung des Spannungsteilers schließlich zu einer starken Abhängigkeit der Klammerspannung vom Kollektorstrom, da sich der zur Aufsteuerung nötige Basisstrom aus dem Kollektorstrom und der Verstärkung ergibt.

Vorteile der Erfindung

Die erfindungsgemäße Halbleiteranordnung mit den Merkmalen des Hauptanspruchs hat demgegenüber den Vorteil, daß durch die unterschiedliche Schichtdicke der Passivierungsschicht ein Oberflächendurchbruch im Bereich des Widerstandsstreifens verhindert wird, da die Oxiddicke in diesem Bereich dicker ausgebildet ist als im Bereich der an den pn-Übergang angrenzenden Raumladungszone. Bei der erfindungsgemäßen Halbleiteranordnung kann es sich beispielsweise um eine Zenerdiode, einen Einzeltransistor oder um eine Darlingtonschaltung handeln. Eine dünnere Passivierungsschicht im Bereich zwischen Sperrstreifen und Basisgebiet des Leistungstransistors einer Darlington-Transistorschaltung hat zur Folge, daß der Sperrstrom des Oberflächendurchbruchs ausschließlich in die Basis des Leistungstransistors fließt. Den jeweiligen Anforderungen entsprechend, insbesondere in Abhängigkeit von der jeweiligen Ausführung der Schaltungsanordnung und der gewünschten Klammerspannung bzw. Durchbruchsspannung, muß die unterschiedliche Dicke der Passivierungsschicht gewählt werden. Bei einer Darlington-Transistorschaltung, die als Ansteuerschaltung für Zündspulen von Kraftfahrzeugen verwendet wird, kann beispielsweise bei einer Klammerspannung von 400 Volt eine um 0,5-1 μm dünnere Passivierungsschicht im Bereich zwischen Sperrstreifen bzw. Stoppring und Basiszone des Leistungstransistors vorgesehen sein als in den übrigen Bereichen.

Vorteilhafte Weiterbildungen ergeben sich aus den übrigen Unteransprüchen.

Zeichnung

Die Erfindung wird nachfolgend anhand der Zeichnungen näher erläutert. Es zeigen :

Figur 1 eine Draufsicht auf eine erfindungsgemäße Halbleiteranordnung,

Figur 2 ein Schaltbild der Schaltung nach Figur 1 und

Figur 3 einen Teilschnitt nach der Linie A-A' der Figur 1.

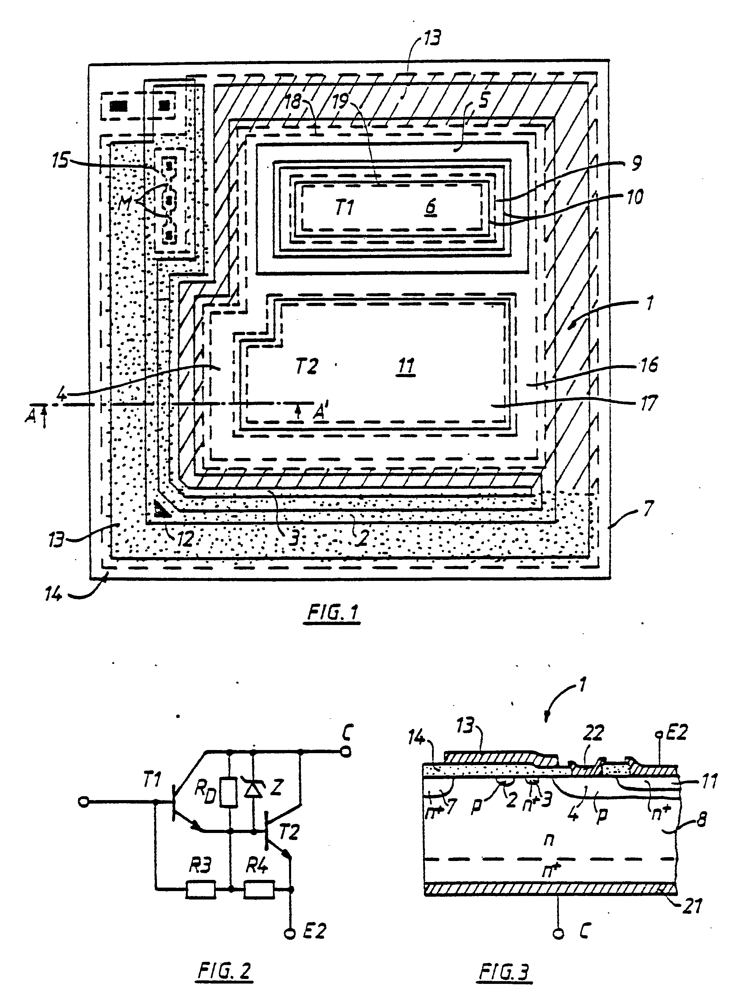

Bei der in Figur 1 dargestellten Draufsicht einer monolithisch integrierten Darlington-Transistorschaltung sind von der Hauptoberfläche 1 her ein Widerstandsstreifen 2, ein Sperrstreifen 3, die Basiszone 4 eines Leistungstransistors T2, ein Trennstreifen 5 und die Basiszone 6 eines Treibertransistors T1 eindiffundiert. Der Sperrstreifen 3 ist mit einem äußeren Stoppring 7 verbunden, der ebenfalls von oben in das Substrat 8 (Figur 3) eindiffundiert ist.

In die Basiszone 6 des Treibertransistors T1 ist dessen Emitterzone 9 eindiffundiert, die ringförmig ausgebildet ist und deren Begrenzung in der Zeichnung durch nicht unterbrochene Linien 10 dargestellt ist. Die Emitterzone 11 des Leistungstransistors T2 ist in dessen Basiszone 4 eindiffundiert.

Auf der Oberfläche befinden sich verschiedene Metallisierungen, deren seitliche Ränder durch unterbrochene Linien dargestellt sind. Eine mit dem Abgriff 12 des Widerstandsstreifens 2 verbundene Deckelektrode 13 bildet eine solche Metallisierung. Diese Deckelektrode 13 ist auf einer Passivierungsschicht 14 aus Siliziumdioxid isoliert gegenüber dem darunter befindlichen Halbleitermaterial angeordnet. Durch die Verbindung mit dem Abgriff 12 des Widerstandsstreifens 2 wird die Deckelektrode 13 auf ein bestimmtes elektrisches Potential gebracht. Dieses elektrische Potential ist abhängig von der Ausbildung des Widerstandsstreifens 2, der zwei Teilerwiderstände R1 und R2 bildet. Durch die Wahl der beiden Teilerwiderstände R1, R2 kann dis Durchbruchsspannung eingestellt werden. Eine ausführliche Beschreibung der Wirkungsweise der Deckelektrode 13 ist in der DE-OS 3 227 536 angegeben.

Über dem linken oberen Teil des Widerstandsstreifens 2 ist in der Deckelektrode 13 eine Aussparung 15 angebracht, die die Passivierungsschicht 14 freilegt. In dem freigelegten Teil der Passivierungsschicht 14 sind Kontaktfenster eingebracht, die durch Kurzschlußmetallisierungen M überbrückbar sind, wodurch der aus dem Widerstandsstreifen 2 bestehende Spannungsteiler abgleichbar ist.

Die übrigen Metallisierungen 16, 17 und 18, 19 schützen die darunter befindlichen Zonen und dienen teilweise als Anschlußelektroden.

Die aus Siliziumdioxid bestehende Passivierungsschicht 14 ist unterhalb der Deckelektrode 13 unterschiedlich stark ausgebildet. Die Gebiete mit dickerer Oxidschicht sind in der Zeichnung punktiert, während der schraffierte Bereich den Bereich mit dünnerer Oxidschicht angibt. Der Bereich mit dünnerer Oxidschicht ist im wesentlichen durch den Sperrstreifen 3, den äußeren Stoppring 7 und die Basiszone 4 des Leistungstransistors T2 begrenzt.

In Figur 2 ist ein Schaltbild der Darlington-Schaltung nach Figur 1 angegeben. Der für die Deckelektrode 13 maßgebliche Widerstand ist in dieser Schaltung mit $R_D$ bezeichnet und zwischen dem gemeinsamen Kollektor C und der Basis des Transistors T2 angeordnet. Durch die dünnere Oxidschicht in dem der Basis des Leistungstransistors T2 benachbarten Gebiet wird gewährleistet, daß der Spannungsdurchbruch zwischen Kollektor C und Basis des Transistors T2 stattfindet. Eine dem Widerstand $R_D$ parallel geschaltete Zenerdiode Z symbolisiert diesen Zusammenhang.

Die weiterhin dargestellten Widerstände R3 und R4, die einen Spannungsteiler zwischen der Basis des Treibertransistors T1 und dem Emitter des Leistungstransistors T2 bilden, sind in der Draufsicht von Figur 1 nicht dargestellt.

Bei dem in Figur 3 dargestellten Teilschnitt ist der Aufbau der monolithisch integrierten Schaltungsanordnung nach Figur 1 entlang der Schnittlinie A-A' ersichtlich. An der Unterseite des Substrates 8 ist eine Metallisierung 21 vorgesehen, die die Anschlußelektrode für den gemeinsamen Kollektoranschluß C bildet. Von der Hauptoberfläche 1 sind in das Substrat 8, welches n-dotiert ist, ein äußerer $n^+$-dotierter Stoppring 7, der p-dotierte Widerstandsstreifen 2, der $n^+$-dotierte Sperrstreifen 3 und die p-dotierte Basiszone 4 des Leistungstransistors T2 eindiffundiert. In die Basiszone 4 ist die $n^+$-dotierte Emitterzone 11 des Leistungstransistors T2 eindiffundiert.

Unter der Deckelektrode 13 befindet sich die aus Siliziumdioxid bestehende Passivierungsschicht 14, die im Bereich zwischen dem Sperrstreifen 3 bzw. dem Stoppring 7 und der Basiszone 4 dünner ausgebildet ist als im übrigen Bereich unterhalb der Deckelektrode 13.

Oberhalb der Basiszone 4 befindet sich eine Metallisierung 22, die seitlich von dem als Isolator dienenden Siliziumdioxid begrenzt wird. Oberhalb der Emitterzone 11 ist eine weitere Metallisierung 23 angebracht, die die Elektrode für den Emitteranschluß E2 bildet.

Durch die dünnere Passivierungsschicht 14 im Bereich zwischen Sperrstreifen 3 bzw. Stoppring 7 und Basiszone 4 wird erreicht, daß ein Oberflächendurchbruch im Bereich des Widerstandsstreifens 2 verhindert wird. Der Sperrstreifen 3 sollte so hoch dotiert sein, daß die Raumladungsgebiete um Basiszone 4 und Widerstandsstreifen 2 voneinander getrennt werden.

## Patentansprüche

1. Monolithisch integrierte planare Halbleiteranordnung, die insbesondere als Darlington-Transistorschaltung mit einem Treibertransistor und einem Leistungstransistor ausgebildet ist, mit wenigstens einem pn-Übergang, der durch das einen bestimmten Leitfähigkeitstyp aufweisende Substrat und eine in das Substrat eindiffundierte Zone entgegengesetzten Leitfähigkeitstyps gebildet ist, mit einer über einer Passivierungsschicht angeordneten Deckelektrode, die die im Sperrbetrieb auftretenden Raumladungsgebiete überdeckt und mit dem Abgriff eines als Widerstandsstreifen im Abstand von dem pn-Übergang eindiffundierten Spannungsteiler verbunden ist, mit einem zwischen dem Widerstandsstreifen und dem pn-Übergang in das Substrat eindiffundierten Sperrstreifen, der mit einem die Halbleiteranordnung begrenzenden äußeren Stoppring verbunden ist, dadurch gekennzeichnet, daß die unterhalb der Deckelektrode (13) angeordnete Passivierungsschicht (14) im Bereich zwischen Widerstandsstreifen (2) und Sperrstreifen (3) und Stoppring (7) dicker ist als im Bereich zwischen Sperrstreifen (3) und dem benachbarten Gebiet des pn-Überganges bzw. zwischen dem Gebiet des pn-Überganges und dem Stoppring (7).

2. Halbleiteranordnung nach Anspruch 1, dadurch gekennzeichnet, daß die als Oxidschicht ausgebildete Passivierungsschicht (14) in den Bereichen mit dünnerer Oxidschicht um etwa 0,5 μm dünner ist als in den übrigen Bereichen unter der Deckelektrode (13).

3. Halbleiteranordnung nach einem der Ansprüche 1 oder 2, dadurch gekennzeichnet, daß Sperrstreifen (3) und Stoppring (7) hoch dotiert sind und denselben Leitfähigkeitstyp wie das Substrat (8) haben.

4. Halbleiteranordnung nach einem der vorhergehenden Ansprüche, dadurch gekennzeichnet, daß die Halbleiteranordnung als Darlington-Transistorschaltung mit wenigstens einem Treibertransistor (T1) und einem Leistungstransistor (T2) ausgebildet ist, deren Kollektorzonen vom Substrat (8) gebildet werden, deren Basiszonen in die Kollektorzone von der Hauptoberfläche aus eindiffundiert sind, und daß die Passivierungsschicht (14) im Bereich zwischen Sperrstreifen (3) bzw. Stoppring (7) und Basiszone (4) des Leistungstransistors (T2) dünner ausgebildet ist als in den übrigen Bereichen unter der Deckelektrode (13).

## Claims

1. Monolithic integrated planar semi-conductor device, which is designed in particular as a Darlington transistor circuit having a drive transistor and a power transistor, having at least one p-n junction which is formed by the substrate of a particular conductivity type and a zone of opposite conductivity type diffused into the substrate, having a cover electrode arranged above a passivation layer, which cover electrode covers the space-charge zones occurring in the stop mode and is connected to the tap of a voltage divider diffused into place as a resistance band at a distance from the p-n junction, having a stop band diffused into the substrate between the resistance band and the p-n junction, which stop band is connected to an outer stop ring delimiting the semi-conductor device, characterized in that the passivation layer (14) arranged below the cover electrode (13) is thicker in the region between resistance band (2) and stop band (3) and stop ring (7) than in the region between stop band (3) and the adjacent zone of the p-n junction or between the zone of the p-n junction and the stop ring (7) respectively.

2. Semi-conductor device according to Claim 1, characterized in that the passivation layer (14) designed as an oxide layer is approximately 0.5 μm thinner in the regions with thinner oxide layer than in the remaining regions under the cover electrode (13).

3. Semi-conductor device according to one of Claims 1 or 2, characterized in that the stop band (3) and stop ring (7) are highly doped and are of the same conductivity type as the substrate (8).

4. Semi-conductor device according to one of the preceding claims, characterized in that the semi-conductor device is designed as a Darlington transistor circuit having at least one drive transistor (T1) and one power transistor (T2), the collector zones of which are constituted by the substrate (8), the base zones of which are diffused into the collector zone from the main surface, and in that the passivation layer (14) is of thinner design in the region between stop band (3) or stop ring (7) respectively and base zone (4) of the power transistor (T2) than in the remaining regions under the cover electrode (13).

## Revendications

1. Dispositif semi-conducteur monolithique à structure plane qui est notamment réalisé sous forme de montage de Darlington à transistor, avec un transistor pilote et un transistor de puissance avec au moins une jonction de type pn, qui est formée par un substrat possédant un certain type de conductivité et une zone qui est diffusée à l'intérieur du substrat, possédant un type de conductivité opposé, avec une électrode de recouvrement qui est disposée sur une couche de passivation et qui recouvre les zones de charge d'espace apparaissant lors du fonctionnement en blocage et qui est relié à la prise d'un diviseur de tension ayant la forme d'une bande de résistance qui est diffusée à l'intérieur, à distance de la jonction de type pn, avec une bande de barrage qui est diffusée à l'intérieur du substrat entre la bande de résistance et la jonction de type pn, et qui est reliée à un anneau d'arrêt extérieur délimitant le dispositif semi-conducteur, caractérisé en ce que, dans la zone comprise entre bande de résistance (2) et bande de barrage (3) et anneau d'arrêt (7), la couche de passivation (14), qui est disposée sous l'électrode de recouvrement (13), est plus épaisse que dans la zone comprise entre bande de barrage (3) et la zone voisine de la jonction de type pn, respectivement entre la zone de la jonction de type pn et l'anneau d'arrêt (7).

2. Dispositif semi-conducteur selon la revendication 1, caractérisé en ce que, dans les zones possédant une couche d'oxyde plus mince, la couche de passivation (14) qui est réalisée sous forme de couche d'oxyde est plus mince d'environ 0,5 μm que dans les autres zones situées au-dessous de l'électrode de recouvrement (13).

3. Dispositif semi-conducteur selon l'une des revendications 1 ou 2, caractérisé en ce que la bande de barrage (3) et l'anneau d'arrêt (7) sont fortement dopés et possèdent le même type de conducteur que le substrat (8).

4. Dispositif semi-conducteur selon l'une des revendications précédentes, caractérisé en ce que le dispositif semi-conducteur est réalisé sous forme de montage Darlington à transistor, avec au moins un transistor pilote (T1) et un transistor de puissance (T2), dont les zones de collecteur sont formées par le substrat (8), dont les zones de base sont diffusées à l'intérieur de la zone de collecteur, en partant de la surface principale et en ce que, dans la zone comprise entre bande de barrage (3), respectivement anneau d'arrêt (7) et zone de base (4) du transistor de puissance (T2), la couche de passivation (14) est réalisée de manière plus mince que dans les autres zones, qui sont situées sous l'électrode de recouvrement (13).

_FIG. 1_

_FIG. 2_

_FIG. 3_